# EUROPEAN PATENT APPLICATION

(11) **EP 2 960 663 A1**
(43) Date of publication of application: **30.12.2015**
(21) Application number: 14173459.0
(22) Date of filing: 23.06.2014
(51) Int. Cl.: G01R 19/25, G01R 13/00

(54) **Method for data acquisition of a current or voltage signal**

(71) Applicant: 3M Innovative Properties Company, Saint Paul, MN 55133-3427 (US)
(72) Inventor: Weinmann, Christian, 52477 Alsdorf (DE); Stalder, Michael, 47589 Uedem (DE); Eggert, Sebastian, 40227 Düsseldorf (DE); Kurzhals, Holger, 47839 Krefeld (DE)
(74) Representative: Bergen, Katja

(57) **Abstract**

The invention relates to a method for data acquisition of a signal representing a current or voltage of a power carrying conductor in a medium or high voltage power network, said signal comprising a waveform of continuously repeating elements, the method comprising the following steps:
a) sampling the signal for a defined first time period to capture a first signal comprising a single period of the waveform with a sensing unit, wherein the sampling is stopped after the defined first time period for a defined second time period;
b) transmitting the first signal with a communication unit from the sensing unit to a central unit;
c) sampling the signal for the defined first time period after the end of the defined second time period with the sensing unit to capture a second signal comprising another single period of the waveform;
d) transmitting the second signal with the communication unit from the sensing unit to the central unit;

wherein the central unit copies the first signal until it receives the second signal form the sensing unit.

## Description

The invention relates to a method for data acquisition of a signal representing a current or voltage of a power carrying conductor in a medium or high voltage power network. The invention also relates to the use of the claimed method in connection with a sensing unit of a medium or high voltage power network.

In the technical field of high or medium voltage power networks there is for example the need of measuring certain parameters, such as for example voltage and/or current at certain locations within the network, such as for example in cable terminations, medium voltage switchgears and/or transformers. There may further be the need for other electronic equipment such as for example an electronic interface or a communication device.

WO 2012/130816 A1 discloses an apparatus for measuring the potential on a cable such as those used in medium voltage distribution networks. The measurement apparatus for measuring the voltage of an insulated electrical cable includes at least one central conductor, a first dielectric layer surrounding the at least one central conductor, a semiconducting layer surrounding the first dielectric layer and a cable shield surrounding the semi-conductive layer. The apparatus comprises a sensing electrode assembly arranged around the cable, comprising a sensing electrode element connected to the semiconductor layer such that the sensing capacitor is formed by the semiconductor layer together with at least one central conductor and at least the first dielectric layer of the insulated electrical cable. An electrical circuit is connected to the sensing electrode element.

These sensing devices and/or according electronics that may for example be needed to transmit data (communication device) or to adapt data to following processes (interface device) require energy. Although the cable, which is sensed, carries energy, it is not so easy to access this energy. Direct galvanic access requires a high amount of technical equipment, because of the high or medium voltage environment. Therefore one solution is the use of a battery providing energy to the above mentioned devices. Another possibility is disclosed in the not yet published patent application filed by the same applicant as the applicant of this application on May 22nd, 2014 with the application number EP 14169529. This application discloses an energy harvesting solution providing energy for the above described devices.

For both solutions - battery powered solution and energy harvesting solution - it may be beneficial, if the processes using the provided energy can be performed in an energy efficient manner.

WO 2004/038891 A2 discloses a device for monitoring an electric overhead line with a sensor unit for collecting data, a transformer for collecting operating power from the line and a communication unit to transmit data to a remote central. In this document it is not mentioned how the above described components are powered. It is further not described how the data collection is performed and if it is done in an energy efficient manner.

WO 2006/128394 A1 discloses a measurement or protective device having an interface for establishing a connection to at least one measurement transducer and having a further interface for connection to a data bus. Data reduction mechanisms are disclosed that only use a percentage of the measured data. Energy efficiency is not mentioned in this document.

In view of the prior art, there is still a need for providing an energy efficient method for data acquisition of a signal representing a current or voltage of a medium or high voltage power carrying conductor.

The current invention provides a method for data acquisition of a signal representing a current or voltage of a power carrying conductor in a medium or high voltage power network, said signal comprising a waveform of continuously repeating elements, the method comprising the following steps:
a) sampling the signal for a defined first time period to capture a first signal comprising a single period of the waveform with a sensing unit, wherein the sampling is stopped after the defined first time period for a defined second time period;
b) transmitting the first signal with a communication unit from the sensing unit to a central unit;
c) sampling the signal for the defined first time period after the end of the defined second time period with the sensing unit to capture a second signal comprising another single period of the waveform;
d) transmitting the second signal with the communication unit from the sensing unit to the central unit;
wherein the central unit copies the first signal until it receives the second signal form the sensing unit.

Data acquisition according to the method of the invention is directed to the measuring or sampling of a parameter or condition - such as for example voltage or current etc. - and collecting or capturing the measured signal as well as reconstructing of the measured or sampled signal. For the measuring or sampling a sensing unit may be used that is able to measure or sample the desired parameter or condition and to collect or capture it for further processing, like analyzing, storing, using for managing a system etc.. One example for a sensing unit that may be used for applying the claimed invention is disclosed in the European Patent EP 2 608 338 B1. Here the embodiment shown for example in Fig. 5 comprises a capacitive voltage sensor. All the features of this sensor are herewith incorporated into the disclosure of the application.

According to the method of the invention, the data that is acquired is a signal comprising a waveform of continuously repeating elements. Thus the signal comprises a multitude of elements and the elements are repeating elements, which means that they resemble each other or that they are identical with each other and they repeat over time one after another. If one element of the signal comprising repeating elements is know, conclusions can be drawn on the entire signal. It is possible, that the signal only comprises repeating elements, thus consists of repeating elements. It is also possible that the signal also comprises other elements besides the repeating elements, e.g. errors, disruptions or noise. The signal according to the method of the invention does - under normal conditions - not change surprisingly. The repeating elements may not differ significantly during a defined time period, e.g. the defined second time period.

A repeating element according to the invention is an element of the signal that has a shape that repeats in an identical or substantially identical way after a certain time span or time interval. One example of a signal with a waveform of continuously repeating elements is a periodic signal.

The method steps of the method according to the invention are
a) sampling the signal with a sensing unit for a defined first time period (first signal), wherein the sampling is stopped after the defined first time period for a defined second time period;
b) transmitting the captured first signal with a communication unit from the sensing unit to a central unit
c)sampling the signal again with the sensing unit for the defined first time period (second signal)
d) transmitting the captured second signal with a communication unit from the sensing unit to the central unit and copying the first signal until the second signal is received .

As mentioned above the measuring or sampling of the signal may be done with a sensing unit that measures and samples the signal of a certain parameter. One sensing unit that may be used in the context of the invention is disclosed in the above already mentioned European Patent EP 2 608 338 B1, embodiment shown in Fig. 5. The transmitting of the captured signal may be done with all known devices like any transceivers running a protocol like for example UART, SPI, I2C or proprietary. The data transmission may use optical ways of data transfer, wireless ways of data transfer, the above mentioned transformers or acoustic ways of data transfer. The central unit, may be located remotely from the sensing unit. Or it may be located close to the sensing unit.

According to the invention, step a) which is the sampling of the signal is only done for a defined first time period, wherein the first time period is selected such that it covers at least a first repeating element - the first signal. In other words the first time period is equal to the time span or time interval that a first repeating element lasts. It is also possible to capture more than one repeating element within the first time period.

The first time period t₁ can for example be determined by using a zero level detector or a zero crossing detector. This is an element that does not need much energy and can be integrated into the sensing unit 2. It detects the instances, where the signal is equal to zero. If the signal comprises a waveform, these instances can be used to identify the starting point and the end point of the repeating element. A sine signal has for example a zero crossing at the beginning, one at the middle and another one at the end. The zero level detector can also be used to exactly define the time where the next measuring or sampling interval starts, which is at the end of the defined second time period.

After the first time period is over, sampling of the signal is stopped. By stopping the sampling process after a defined first time period, which is a process that needs energy, energy can be saved. In addition, energy is also saved during step b), which is the transmitting step. Since only a limited amount of information about the signal is sampled during step a), only this limited amount of information needs to be transmitted from the sensing unit to the central unit, which also saves energy.

The sampling is stopped for a defined second time period. The defined second time period needs to be selected such that it covers a time span in which the signal - under normal conditions - has a shape that repeats in an identical or substantially identical way. The defined second time period may depend on the application and the conditions of the medium or high voltage power network, the method according to the invention is applied. It may also depend on the amount of energy that is available at the sensing unit.

Finally, the central unit copies the received first signal until it receives the second signal. By copying the first signal, the signal to be monitored gets reconstructed. During the sampling and the transmitting step, energy can be saved. The copying step is performed at the central unit, where energy is usually available.

Sampling of the signal comprising a waveform of continuously repeating elements for the defined first time period is repeated periodically immediately after the second time period is over. In such a process sampling of the signal is always repeated after non sampling of the signal is over. Depending on the kind of data that is acquired or monitored the second time period may be selected longer or shorter as the first time period. It may also be selected as long as the first time period. Depending on the risk and the speed with which the measured or monitored signal may change, the second time period may be adapted as well.

According to one embodiment of the invention sampling of the signal comprising a waveform of continuously repeating elements for the defined first time period is repeated periodically. Repeating the sampling process after stopping the sampling provides an energy efficient data acquisition process that acquires data again and again with defined pauses in between. Such a method can for example be used to monitor, measure or sample data over an indefinite period of time.

According to another embodiment of the invention, the signal comprising a waveform of continuously repeating elements may be a sine signal. It may be a sine signal with or without harmonics. Another example of a signal comprising continuous repeating elements is a cosine signal. Generally speaking the signal may be any periodically repeating waveform, such as for example but not limiting a square waveform, a triangle waveform or a ramp waveform.

According to another embodiment of the invention, the frequency of the sine signal may be 50 Hz. 50 Hz is the base frequency of European power networks. All other frequencies are possible as well, such as for example 60 Hz, which is the base frequency of the US power networks, or 16 2/3 Hz. The frequencies according to the invention cover all network frequencies and their harmonic frequencies.

According to another embodiment of the invention, the defined first time period is selected such that a single period of the waveform is captured or sampled. If the frequency of the signal is 50 Hz the defined first time period may for example be 1/50 of a second and the defined second time period may be 49/50 of a second. It should be noted that 49/50 of a second is just an example. Every other time period is possible as well for the second time period, e.g. 25/50 of a second or 30/50 of a second or 40/50 of a second, as long as it is a multiple of the defined first time period. It is also possible to define the first time period with 2/50 or more and to define the second time period with 48/50 or more or less. As described above the time periods need to be defined depending on the application the method according to the invention is applied to and the amount of energy that is available at the sensing unit. If the frequencies are other than 50 Hz, the defined first time period needs to be adapted accordingly to still cover one period of the waveform signal, such as for example 1/60 etc.. The defined second time period needs to be adapted as to fulfill the requirements of the application and the energy needed to perform the method of data acquisition.

According to another embodiment of the invention, the transmitting of the sampled signal comprising a waveform of continuously repeating elements with a communication unit from a sensing unit to a central unit is performed during the defined second time period. Transmitting the data signal after sampling it, provides the advantage that the total amount of energy needed at one point in time is less. But it is of course also possible to transmit the data signal parallel to capturing it, which would mean that the transmitting of the sampled signal comprising a waveform of continuously repeating elements is performed - at least partially - during the defined first time period.

According to another embodiment of the invention, points of interest of the signal comprising a waveform of continuously repeating elements may be captured during the defined second time period. The defined second time period may be much longer than the defined first time period - as already pointed out above. To minimize the risk that the measured parameters change drastically within the second time period without being captured, it is suggested as one option to capture so called points of interest during the time period where no continuous sampling is performed. Points of interest may be any points of the signal comprising a waveform of continuously repeating elements that may give useful information. The points of interest may for example be the maximum and/or the minimum amplitude of the waveform of continuously repeating elements. If the signal comprising a waveform of continuously repeating elements is a sine signal, the points of interest may be for example the first positive peak (maximum) and/or the first negative peak (minimum). From the sampled first signal, it can be calculated, where the maximum and the minimum of the waveform lies. If the signal is for example a sine signal, the maximum is located at 1/4 of the defined first time period and the minimum is located at 3/4 of the defined first period of time. Therefore, if those points of interest need to be monitored, sampling would only be performed at exact this time. It is also possible to use a detector of the time, where the signal is equal to zero (zero level detector or zero crossing detector). If the signal is a sine signal, maximum and minimum are located in the middle of those two times.

According to another embodiment of the invention, the captured points of interest are transmitted with the communication unit from the sensing unit to the central unit. The transmission of the points of interest may be performed during the defined second time period. The captured points of interest may also be kept within the sensing unit. Further processing of the captured points of interest may take place in the sensing unit or in the central unit.

According to another embodiment of the invention, the points of interest are compared with previous points of interest of the signal comprising a waveform of continuously repeating elements. This comparison may be done at the sensing unit itself or at the central unit.

According to another embodiment of the invention, if a change of the captured points of interest is detected, an action may be triggered. The action may be that sampling of the signal is started again. The sampling of the signal may be started immediately after the change of the captured points of interest is detected. The sampled data may be transmitted with the communication unit from the sensing unit to the central unit.

A possible method of carrying out the capturing of the points of interest during the defined second time period may comprise the follow steps:
a) sensing unit captures and saves the points of interest;
b) sensing unit compares the points of interest with each other;
c) if a change is detected, that lies under a defined threshold, nothing happens;
d) if a change is detected, that lies above a defined threshold, sampling of the signal may be started and the sampled signal may be transmitted to the central unit.

In order to improve the resolution of the reconstructed data oversampling can be used. For example the sample rate of the sensing unit is relatively low. For example it has been chosen to capture the 50^{th} harmonic of the base frequency (50 Hz *50 = 2,5 kHz) which is 200 us (5 kHz). This may be good for power saving of the sensor. This may also bare the risk that the frequency resolution is lowered as this will stick to the sampling grid. With this sampling rate, the frequency resolution would be 0,5 Hz. This might not be accurate enough for some applications.

To improve the frequency resolution, the sensor may measure the time of the sampled period more precisely and send this value together with the 200 sample-values to the central unit. This value may be named period time. To benefit from this additional information the central unit may mathematically enlarge the sample rate by introducing a second, finer grid over the sampling grid which is called oversampling grid. The central unit may generate additional samples between each "real" sample by interpolating the missing values. Now the period length of the sampled waveform can be altered in much finer steps resulting in a higher frequency resolution.

Using for example a 4 times oversampling will generate 3 additional values between each "real" sample-value. These results in a shorter time-interval between each sample (before: 200 us, after 50 us). The frequency resolution would rise from 0,5Hz to 0,125 Hz.

Depending on the processor-performance, much higher oversampling (e.g. 64 times, 128times) is also possible. This also has the advantage that, when using digital-to-analog conversion in an output interface, the design of the output filter is much simpler because the sampling frequency is more far away from the frequencies of interest through this process.

The invention also relates to the use of a method for data acquisition according to the above described method in a sensing unit of a medium or high voltage power network. The medium or high voltage power network may be a system providing a power carrying conductor. The power carrying conductor may be provided in arrangements, such as for example terminations, splices, switches, transformers, fittings and/or sleeves.

The invention will now be described in more detail with reference to the following Figures exemplifying particular embodiments of the invention:
- Fig. 1: flow chart of one embodiment of a method for data acquisition according to the invention;
- Fig. 2: one example of a signal comprising a waveform of continuously repeating elements over time;
- Fig. 3: one example of the captured signal according to Fig. 2; and
- Fig. 4: one example of the reconstructed captured signal according to Fig. 2 and Fig. 3.

Herein below various embodiments of the present invention are described and shown in the drawings wherein like elements are provided with the same reference numbers.

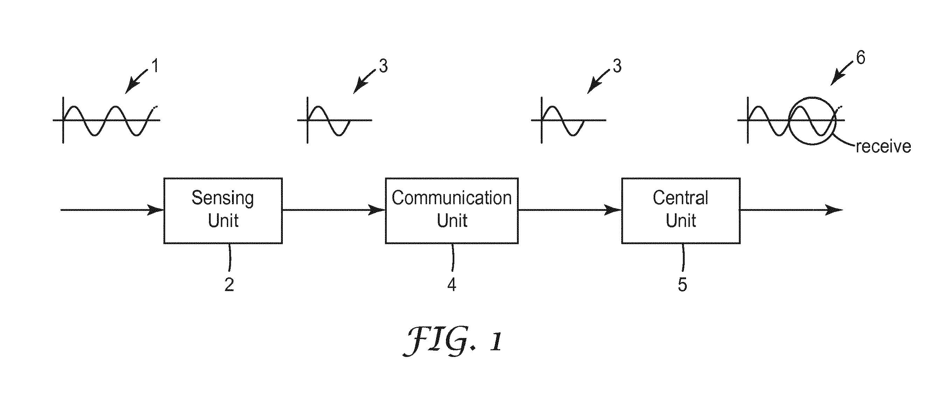

Fig. 1 shows a flow chart of one embodiment of a method for data acquisition according to the invention. Reference number 1 indicates a signal comprising a waveform of continuously repeating elements, here a sine signal, to be monitored or measured. The signal 1 gets measured with a sensing unit 2. According to the invention, the sensing unit 2 captures only the first repeating element - first signal - indicated with the reference number 3 of the signal comprising a waveform of continuously repeating elements 1 for a defined first time period t₁. After having captured the first repeating element 3, first signal, the sensing unit 2 stops measuring for a defied second time period t₂. The length of the second time period may depend on the kind of system that is monitored, on the power supply of the sensor etc.. After the second time period t₂ is over, the process starts from the beginning with sampling of the signal for the defined first time period t₁.

The first time period t₁ can for example be determined by using a zero level detector or a zero crossing detector. This is an element that does not need much energy and can be integrated into the sensing unit 2. It detects the instances, where the signal is equal to zero. If the signal comprises a waveform, these instances can be used to identify the starting point and the end point of the signal. The zero level detector can also be used to exactly define the time where the next measuring or sampling interval starts.

It is also possible to calculate t₁ from already sampled data, which does require, before t₁ is defined, sampling needs to start. Afterwards t₁ can be defined and the sampling for the defined first period of time can start.

The first repeating element 3 or first signal is transmitted with a communication unit 4 from the sensing unit 2 to a central unit 5. The central unit 5 receives the captured first repeating element 3. Since following systems would not be able to process this kind of cut of data, the central unit 5 reconstructs the original signal 1 comprising a waveform of continuously repeating elements by copying the captured first repeating element 3, and adding it to or behind the captured first repeating element 3 as often as necessary until a second signal is received. By doing this a continuous data stream is received, which can be send to the next level system for further processing.

This process may be repeated as often as necessary to receive a reconstructed continuous signal. One option, if the repeating element of the to be sampled signal for example repeats with a frequency of 50 Hz the method according to the invention may be performed as follows:
The defined first time period takes t₁ 1/50 of a second and is long enough to catch the first repeating element or first signal 6 of the sine signal. The defined second time period t₂ takes 49/50 of a second. In this time period no continuous capturing or sampling of the signal is performed. In other words, every second the first repeating element of the signal is captured or sampled. For the rest of the second no capturing or sampling, at least no continuous capturing or sampling is performed. The capturing or sampling of the signal is therewith reduced from 50 periods per second to one period per second. This can be done, if the assumption can be made that the signal itself will not change continuous and is therewith stable during the time > 1 second.

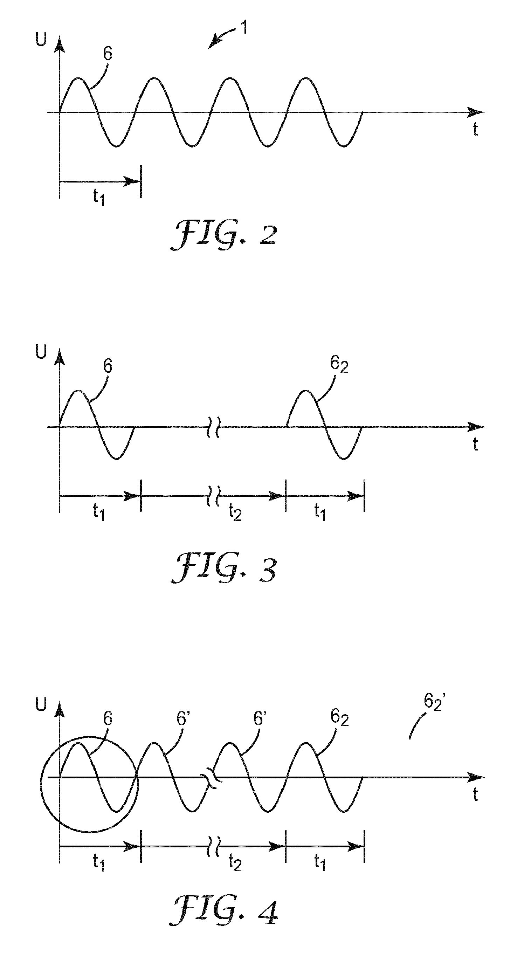

In Fig. 2 one example of a signal comprising a waveform of continuously repeating elements over time is shown. The signal is a sine signal with continuous repeating elements 6 showing a voltage signal U over the time t. Here the repeating elements 6 are one period or one harmonic of the sine signal. The repeating element 6 or first signal lasts the defined time period t₁.

Fig. 3 shows the captured signal - first signal 6 - of the voltage U over the time t. It can be seen that only the first repeating element is sampled. After that the sampling is stopped for a defined second time period t₂.

Fig. 4 shows the reconstructed signal starting with the captured repeating element or first signal 6. The central unit reconstructs the signal by copying the captured repeating element thereby receiving a copied repeating element 6' and adding the copied repeating element 6' to or behind the captured repeating element 6. The copied repeating element 6' is added to the captured repeating element 6 as often as needed until the second signal 6₂ is sampled. When the defined second time period t₂ is 49/50 of a second, the copied repeating element 6' is added 49 times to the first captured repeating element 6. Afterwards the process starts new and a new repeating element indicated as 6₂ is sampled by the sensing unit 2 and transmitted to the central unit 5 with a communication unit 4.

The method according to the invention works as long as no unexpected situation arises. If for example a short circuit occurs, the reaction time might be too long in order to prevent greater damage. To avoid this, according to one embodiment of the invention during the defined second time period t₂ points selected of interest can be measured and compared with each other and/or a defined threshold. The sensor can for example "keep an eye" on the waveform of the signal, even when sampling is not active. This can be done by taking single samples on the maximum amplitude of the waveform (at 1/4 of the period length) or the minimum amplitude of the waveform (at 3/4 of the period length).

## Claims

1. Method for data acquisition of a signal representing a current or voltage of apower carrying conductor in a medium or high voltage power network, said signal comprising a waveform of continuously repeating elements, the method comprising the following steps:
a) sampling the signal for a defined first time period to capture a first signal comprising a single period of the waveform with a sensing unit, wherein the sampling is stopped after the defined first time period for a defined second time period;
b) transmitting the first signal with a communication unit from the sensing unit to a central unit;
c) sampling the signal for the defined first time period after the end of the defined second time period with the sensing unit to capture a second signal comprising another single period of the waveform;
d) transmitting the second signal with the communication unit from the sensing unit to the central unit;
wherein the central unit copies the first signal until it receives the second signal form the sensing unit.

2. Method for data acquisition according to claim 1, wherein sampling the signal for the defined first time period is repeated periodically.

3. Method for data acquisition according to claim 1 or 2, wherein the signal is a sine signal.

4. Method for data acquisition according to claim 3, wherein the frequency of the sine signal is 50 Hz.

5. Method for data acquisition according to any of the preceding claims, wherein the defined first time period is selected such that a single period of the waveform is captured.

6. Method for data acquisition according to any of the preceding claims, wherein the defined first time period is 1/50 of a second.

7. Method for data acquisition according to any of the preceding claims, wherein the defined second time period is 49/50 of a second.

8. Method for data acquisition according to any of the preceding claims, wherein transmitting of the sampled signal comprising a waveform of continuously repeating elements is performed during the defined second time period.

9. Method for data acquisition according to any of the preceding claims, wherein during the defined second time period points of interest of the signal comprising a waveform of continuously repeating elements are captured.

10. Method for data acquisition according to any of the preceding claims, wherein the points of interest are the maximum and/or the minimum amplitude of the waveform of continuously repeating elements.

11. Method for data acquisition according to any of the preceding claims, wherein the captured points of interest are transmitted with the communication unit from the sensing unit to the central unit immediately after they have been captured.

12. Method for data acquisition according to any of the claims 1 to 10, where the captured points of interest are kept within the sensing unit.

13. Method for data acquisition according to any of the preceding claims, wherein the points of interests are compared with previous points of interest of the signal comprising a waveform of continuously repeating elements.

14. Method for data acquisition according to any of the preceding claims, wherein, if a change of the captured points of interest is detected, sampling of the signal is started.

15. Use of a method for data acquisition according to any of the claims 1 to 14 in connection with a sensing unit of a medium or high voltage power network.
